# EUROPEAN PATENT APPLICATION

(11) **EP 4 625 550 A1**
(43) Date of publication of application: **01.10.2025**
(21) Application number: 24866753.7
(22) Date of filing: 01.02.2024
(51) Int. Cl.: H01M 4/66, H01M 4/134, H01M 10/052, C23C 14/16, C23C 14/34, C23C 14/58, C23C 16/06, C23C 16/56

(54) **NEGATIVE ELECTRODE CURRENT COLLECTOR AND PREPARATION METHOD THEREFOR, NEGATIVE ELECTRODE SHEET, LITHIUM METAL BATTERY, AND ELECTRIC DEVICE**

(30) Priority: 18.09.2023 CN 202311196336
(71) Applicant: Contemporary Amperex Technology Co., Limited, Ningde, Fujian 352100 (CN)
(72) Inventor: ZHENG, Yilin, Ningde, Fujian 352100 (CN); GUAN, Wenhao, Ningde, Fujian 352100 (CN); GE, Xiaoming, Ningde, Fujian 352100 (CN)
(74) Representative: Herrmann, Uwe
(86) International application number: PCT/CN2024/075300
(87) International publication number: WO 2025/060326

(57) **Abstract**

A negative electrode current collector and a preparation method therefor, a negative electrode plate, a lithium metal battery, and an electrical apparatus. The negative electrode current collector comprises a copper substrate and a plating layer arranged on the copper substrate, wherein the plating layer comprises a lithium-philic metal and a lithium-philic metal-copper alloy. The negative electrode current collector has good cycling stability, and can help to improve the cycling performance of the lithium metal battery when applied to the lithium metal battery.

## Description

### CROSS-REFERENCE TO RELATED APPLICATION

The patent document claims the priority and rights to Chinese Patent Application No. 202311196336.5 filed on September 18, 2023 and entitled "NEGATIVE ELECTRODE CURRENT COLLECTOR AND PREPARATION METHOD THEREFOR, NEGATIVE ELECTRODE PLATE, LITHIUM METAL BATTERY, AND ELECTRICAL APPARATUS". The entire content of the above patent application is incorporated by reference as part of the disclosure of the present patent document.

### TECHNICAL FIELD

The present application relates to the field of batteries, more specifically to a prepared negative electrode current collector and a preparation method therefor, a negative electrode plate, a lithium metal battery, and an electrical apparatus.

### BACKGROUND

Lithium-ion batteries have developed tremendously in recent years. In lithium-ion batteries, graphite is usually used as a negative electrode active material, which has a limited theoretical capacity, limiting the energy density of the lithium-ion batteries. In lithium metal batteries, as a special type of lithium-ion batteries, high-energy-density lithium metal is used as a negative electrode active material and is considered to be one of the important development directions of lithium-ion batteries.

The surface of the negative electrode current collector is usually provided with a lithium-philic plating layer to facilitate the deposition of lithium metal. Existing plating layers easily fall off during the cycling of lithium metal batteries, which seriously threatens the performance of lithium metal batteries. Therefore, how to improve the stability of a lithium metal negative electrode current collector has become an urgent technical problem to be solved.

### SUMMARY OF THE INVENTION

In view of the above technical problems, the present application aims to provide a negative electrode current collector and a preparation method therefor, a negative electrode plate, a lithium metal battery, and an electrical apparatus. The negative electrode current collector prepared by this method, when applied to a lithium metal battery, can effectively improve the stability of the negative electrode current collector and help improve the cycling performance of the lithium metal battery.

In a first aspect, a method for preparing a negative electrode current collector is provided, comprising: preparing a plating film on a copper substrate; and subjecting the copper substrate prepared with the plating film to an annealing treatment at a preset temperature T to obtain the negative electrode current collector. The plating film comprises a lithium-philic metal.

In an embodiment of the present application, the copper substrate is subjected to an annealing treatment after the plating film is prepared, and the plating film comprises a lithium-philic metal. Thus, the negative electrode current collector obtained after annealing comprises a copper substrate and a plating layer arranged on the copper substrate. The bonding force between the plating layer and the copper substrate in the negative electrode current collector is enhanced, thereby improving the stability of the negative electrode current collector. The current collector, when applied to a lithium metal battery, does not easily fall off during the cycling of the battery, which effectively improves the cycling performance of the lithium metal battery. In addition, the annealing treatment also helps to make the plating layer more evenly distributed on the surface of the copper substrate. Therefore, when applied to a lithium metal battery, it can make the deposition of the lithium metal more even, reduce the possibility of generation and growth of lithium dendrites, and improve the cycling performance of the lithium metal battery.

In one possible implementation, an annealing atmosphere of the annealing treatment comprises at least one of nitrogen, argon, a nitrogen-hydrogen mixed gas, and a mixed gas of an inert gas and hydrogen.

In the embodiments of the present application, by selecting the above atmosphere of the annealing treatment, the possibility of oxidation of the current collector and the plating film can be effectively reduced.

In one possible implementation, in the mixed gas of the inert gas and hydrogen, the volume content of hydrogen, V_{H2}%, satisfies 1% ≤ V_{H2}% ≤ 2%, optionally, 1% ≤ V_{H2}% ≤ 1.5%.

In the embodiments of the present application, by using hydrogen as a reducing gas in the mixed gas, the possibility of oxidation of the current collector and the plating film during the annealing treatment can be further reduced. Furthermore, controlling the volume content of the reducing gas in the mixed gas within an appropriate range helps to reduce the probability of safety accidents caused by an excessively high content of the reducing gas while reducing the possibility of oxidation of the current collector and the plating layer.

In one possible implementation, the lithium-philic metal comprises at least one of Sn, Mg, Zn, Bi, Pb, Au, Ag, or Al.

In one possible implementation, the copper substrate includes copper foil and foam copper; optionally, the copper substrate is foam copper.

In the embodiments of the present application, three-dimensional porous foam copper can be selected as the copper substrate. The foam copper has a relatively large specific surface area, so that the current density on the current collector is relatively small, which can effectively improve the precipitation of lithium and the growth of lithium dendrites.

In one possible implementation, before the annealing treatment, the method further comprises rolling the plated copper substrate.

In one possible implementation, where the lithium-philic metal includes Sn, T satisfies 200°C ≤ T ≤ 800°C; or where the lithium-philic metal includes Mg or Zn, T satisfies 500°C ≤ T ≤ 1000°C; or where the lithium-philic metal includes Bi, T satisfies 450°C ≤ T ≤ 650°C; or where the lithium-philic metal includes Pb, T satisfies 600°C ≤ T ≤ 800°C; or where the lithium-philic metal includes Au, T satisfies 900°C ≤ T ≤ 1100°C; or where the lithium-philic metal includes Ag, T satisfies 800°C ≤ T ≤ 1000°C; or where the lithium-philic metal includes Al, T satisfies 600°C ≤ T ≤ 700°C.

In the embodiments of the present application, depending on the type of the lithium-philic metal in the plating film, different preset temperatures T are set for the annealing treatment. Depending on the type of the lithium-philic metal in the plating film, the preset temperature T is controlled within an appropriate range, so that the lattice structure of the copper substrate will not be destroyed while the bonding force between the plating layer and the copper substrate is improved after annealing. When applied to a lithium metal battery, it does not affect the performance of the lithium metal battery.

In one possible implementation, T is greater than or equal to the melting point of the lithium-philic metal.

In the embodiments of the present application, setting T to be greater than or equal to the melting point of the lithium-philic metal is more conducive to mutual diffusion between the lithium-philic metal and the copper substrate, which helps to further improve the bonding force between the plating layer and the copper substrate.

In one possible implementation, the negative electrode current collector is applied to a lithium metal battery.

In one possible implementation, the preparation of the plating film on the copper substrate comprises: preparing the plating film on the copper substrate by magnetron sputtering.

In one possible implementation, the areal density ρ of the plating film satisfies 2 g/m² ≤ ρ ≤ 4 g/m², optionally, 2 g/m² ≤ ρ ≤ 3 g/m².

In one possible implementation, the holding time t of the annealing treatment satisfies 20 min ≤ t ≤ 60 min, optionally, 25 ≤ t ≤ 40 min.

In the embodiments of the present application, controlling the time of the annealing treatment within an appropriate range helps to facilitate the production and manufacturing of the current collector while obtaining a negative electrode current collector with improved cycling performance of the battery.

In one possible implementation, the preparation of the plating film on the copper substrate comprises: preparing the plating film on the copper substrate by chemical electroplating.

In one possible implementation, the areal density ρ of the plating film satisfies 1.5 g/m² ≤ ρ ≤ 3 g/m².

In one possible implementation, the holding time t of the annealing treatment satisfies 30 min ≤ t ≤ 60 min.

In one possible implementation, where the lithium-philic metal includes Sn, T satisfies 700°C ≤ T ≤ 800°C.

In one possible implementation, the heating rate v of the annealing treatment satisfies 2°C/min ≤ v ≤ 3°C/min.

In a second aspect, a negative electrode current collector is provided, which comprises a copper substrate and a plating layer arranged on the copper substrate. The plating layer comprises a lithium-philic metal and a lithium-philic metal-copper alloy.

In one possible implementation, the lithium-philic metal comprises at least one of Sn, Mg, Zn, Bi, Pb, Au, Ag, or Al.

In one possible implementation, the copper substrate includes at least one of copper foil and foam copper; optionally, the copper substrate is foam copper.

In one possible implementation, In one possible implementation, the negative electrode current collector is prepared by an annealing treatment, and the annealing temperature of the annealing treatment is preset temperature T. Where the lithium-philic metal includes Sn, T satisfies 400°C ≤ T ≤ 600°C; or where the lithium-philic metal includes Mg or Zn, T satisfies 500°C ≤ T ≤ 1000°C; or where the lithium-philic metal includes Bi, T satisfies 450°C ≤ T ≤ 650°C; or where the lithium-philic metal includes Pb, T satisfies 600°C ≤ T ≤ 800°C; or where the lithium-philic metal includes Au, T satisfies 900°C ≤ T ≤ 1100°C; or where the lithium-philic metal includes Ag, T satisfies 800°C ≤ T ≤ 1000°C; or where the lithium-philic metal includes Al, T satisfies 600°C ≤ T ≤ 700°C.

In one possible implementation, T is greater than or equal to the melting point of the lithium-philic metal.

In one possible implementation, the negative electrode current collector is applied to a lithium metal battery.

In one possible implementation, the plating layer is prepared by magnetron sputtering and an annealing treatment.

In one possible implementation, the plating layer is prepared by chemical electroplating and an annealing treatment.

In a third aspect, a negative electrode plate is provided. The negative electrode plate comprises the negative electrode according to any one possible implementation of the first aspect or a negative electrode current collector prepared by the method according to any one possible implementation of the second aspect.

In a fourth aspect, a lithium metal battery is provided. The lithium metal battery comprises the negative electrode plate according to any one possible implementation of the third aspect.

In one possible implementation, the negative electrode plate is the negative electrode current collector.

In a fifth aspect, an electrical apparatus is provided. The electrical apparatus comprises the lithium metal battery according to any one possible implementation of the fourth aspect.

### DESCRIPTION OF DRAWINGS

In order to more clearly illustrate the technical solutions of the embodiments of the present application, the drawings required in the embodiments of the present application will be described briefly below. Apparently, the drawings described below depict merely some embodiments of the present application. For those of ordinary skill in the art, other drawings can also be obtained based on these drawings without any creative effort.
FIG. 1 is a schematic flowchart of a method for preparing a negative electrode current collector according to the present application.
FIG. 2 is another schematic flowchart of a method for preparing a negative electrode current collector according to the present application.
FIG. 3 is a schematic view of a negative electrode current collector according to the present application.
FIG. 4 is a schematic view of a lithium metal battery cell according to the present application.
FIG. 5 is a schematic view of a battery module according to the present application.
FIG. 6 is a schematic view of a battery according to the present application.
FIG. 7 is another schematic view of a battery according to the present application.
FIG. 8 is an SEM image of a negative electrode current collector according to the present application.
FIG. 9 is an EDS image of the negative electrode current collector in FIG. 8.
FIG. 10 is another SEM image of a negative electrode current collector according to the present application.
FIG. 11 is an EDS image of the negative electrode current collector in FIG. 10.
FIG. 12 is another SEM image of a negative electrode current collector according to the present application.
FIG. 13 is an EDS image of the negative electrode current collector in FIG. 12.
FIG. 14 is XRD patterns of an example of the present application and a comparative example.

### DETAILED DESCRIPTION

Hereinafter, embodiments of the method for preparing a negative electrode current collector, the negative electrode current collector, the negative electrode plate, and the electrical apparatus according to the present application are specifically disclosed with appropriate reference to the accompanying drawings. However, there may be cases where unnecessary detailed descriptions are omitted. For example, there are cases where detailed descriptions of well-known items and repeated descriptions of actually identical structures are omitted. This is to avoid unnecessary redundancy in the following descriptions and to facilitate understanding by those skilled in the art. In addition, the drawings and subsequent descriptions are provided for those skilled in the art to fully understand the present application, and are not intended to limit the subject matter recited in the claims.

The "ranges" disclosed in the present application are defined in the form of lower and upper limits. A given range is defined by selecting a lower limit and an upper limit, and the selected lower and upper limits define the boundaries of the particular range. The range defined in this way may include or may not include end values, and may be arbitrarily combined, that is, any lower limit can be combined with any upper limit to form a range. For example, if the ranges 60-120 and 80-110 are listed for specific parameters, it is understood that the ranges 60-110 and 80-120 are also expected. In addition, if the listed minimum range values are 1 and 2 and if the listed maximum range values are 3, 4, and 5, the following ranges can all be expected: 1-3, 1-4, 1-5, 2-3, 2-4, and 2-5. In the present application, unless otherwise specified, the numerical range "a-b" represents an abbreviated representation of any combination of real numbers between a and b, where a and b are both real numbers. For example, the numerical range "0-5" indicates that all real numbers between "0-5" have been listed herein, and "0-5" is only a shortened representation of these numerical combinations. In addition, when a parameter is expressed as an integer ≥ 2, it is equivalent to disclosing that the parameter is, for example, an integer of 2, 3, 4, 5, 6, 7, 8, 9, 10, 11, 12, etc.

In the description of the present application, it needs to be noted that unless otherwise specified, the "plurality of" means two or more; and the directions or position relationships indicated by the terms "above", "below", "left", "right", "inner", "outer", etc., are only provided to facilitate the description of the present application and simplify the description, rather than indicating or implying that the apparatus or element referred to must have a specific direction, or be constructed and operated in a specific direction, and therefore cannot be construed as limiting the present application. In addition, the terms "first", "second", "third", etc., are only for the purpose of description, and cannot be construed as indicating or implying the relative importance.

Unless otherwise specifically specified, in the present application, the term "and/or" is inclusive. By way of example, the phrase "A and/or B" indicates "A, B, or both A and B". More specifically, any one of the following conditions satisfies the condition "A and/or B": A is true (or present) and B is false (or absent); A is false (or absent) and B is true (or present); or both A and B are true (or present).

Unless otherwise specified, all the steps in the present application can be carried out, either in order or randomly, preferably in order. For example, the method comprises steps (a) and (b), which means that the method may comprise steps (a) and (b) performed in order, or may comprise steps (b) and (a) performed in order. For example, reference to "the method may further include step (c)" indicates that step (c) may be added to the method in any order, for example, the method may comprise steps (a), (b), and (c), or steps (a), (c), and (b), or steps (c), (a), and (b), etc.

Unless otherwise specified, all the embodiments and optional embodiments of the present application can be combined with each other form new technical solutions.

Unless otherwise particularly specified, the following terms have the following meanings. Any undefined terms have their technically accepted meanings.

If mentioned, "lithium-philic metal" refers to a metal that can induce lithium deposition. Examples are Mg, Sn, Ag, etc.

If mentioned, "magnetron sputtering" refers to the phenomenon in which high-energy particles are used to bombard a solid surface, and atoms and molecules on the solid surface exchange kinetic energy with the incident high-energy particles and then sputtered out from the solid surface.

If mentioned, "magnetron sputtering plating" refers to a process of plating a film by magnetron sputtering. Specifically, the atoms, atomic groups, or molecules sputtered by magnetron sputtering have a certain amount of energy, and they can be redeposited and condensed on the surface of a solid substrate to form a thin film.

If mentioned, "chemical electroplating" refers to a process of preparing a plating layer on a substrate by an electrochemical reaction.

If mentioned, "annealing treatment" refers to a heat treatment method in which a material is heated to a certain temperature at a certain heating rate, maintained for a period of time, and then cooled at a certain cooling rate.

Next, embodiments of the present application are introduced.

In recent years, secondary batteries have been widely used in many fields, e.g., power tools, electronic products, electric vehicles, and aerospace, due to their relatively high energy density and relatively long service life, so that they have achieved great development. Generally, the secondary battery comprises a positive electrode plate, a negative electrode plate, an electrolyte solution, and a separator. During the charging and discharging process of the battery, active ions are intercalated and deintercalated back and forth between the positive electrode plate and the negative electrode plate. The electrolyte solution serves to conduct active ions between the positive electrode plate and the negative electrode plate. The separator is arranged between the positive electrode plate and the negative electrode plate to enable active ions to pass through while preventing the positive electrode plate and negative electrode plate from short circuit, so that the electrochemical reaction in the secondary battery occurs normally.

Taking a lithium-ion battery as an example, the lithium-ion battery, a typical secondary battery, is also known as a rocking chair battery due to the fact that it is charged and discharged relying on a chemical reaction of deintercalation of lithium ions between the positive electrode and the negative electrode. During the charging process of the lithium-ion battery, lithium ions are deintercalated from a positive electrode active material, moved to the negative electrode by conduction in the electrolyte solution, and then intercalated into a negative electrode active material; and during the discharging process, the lithium ions are deintercalated from the negative electrode active material, moved to the positive electrode by conduction in the electrolyte solution, and then intercalated into the positive electrode active material.

It is to be understood that the process of "lithium intercalation" and "intercalation" described in the present application refers to a process in which lithium ions are intercalated in the positive electrode active material or the negative electrode active material due to the electrochemical reaction, and the process of "deintercalation", "lithium deintercalation", and "removal" described in the present application refers to a process in which lithium ions are deintercalated in the positive electrode active material or the negative electrode active material due to the electrochemical reaction.

In lithium-ion batteries, graphite is usually used as a negative electrode material, which has a relatively limited theoretical capacity, limiting the development of the lithium-ion batteries. Lithium metal batteries are a special class of lithium-ion batteries in which metallic lithium is directly used as the negative electrode active material. The theoretical capacity of the lithium metal negative electrode is as high as 3860 mAh g⁻¹, which makes the lithium metal battery have a higher energy density. The lithium metal battery is called a new generation of lithium-ion battery with great development potential.

During the preparation of a lithium metal battery, a lithium plate can be directly used as a negative electrode, or the negative electrode current collector can be directly arranged in the battery as a negative electrode plate. The negative electrode of the lithium metal battery is formed by the lithium ions released from the positive electrode plate and deposited on the negative electrode current collector during the charging process. In order to facilitate the deposition of lithium ions on the negative electrode current collector, a lithium-philic plating layer is usually provided on the negative electrode current collector.

During the cycling of the lithium metal battery, due to the continuous alloying and dealloying reactions of lithium in the plating layer, plating layer detachment extremely easily occurs during cycling, which seriously threatens the cycling performance of the lithium metal battery. In addition, there is also a case where the thickness of the plating layer is uneven, which makes the deposition of lithium ions on the surface thereof uneven, thereby leading to agglomeration of lithium metal on part of the surface, and in severe cases, lithium dendrites are formed, which pierces the separator and causes safety problems.

In view of this, the present application provides a method for preparing a negative electrode current collector, a negative electrode current collector, a negative electrode plate, and a lithium metal battery. The negative electrode current collector prepared by this method has good cycling stability and can effectively improve the cycling performance of a lithium metal battery when applied to the lithium metal battery.

Next, this method is first introduced in detail.

### [Preparation method]

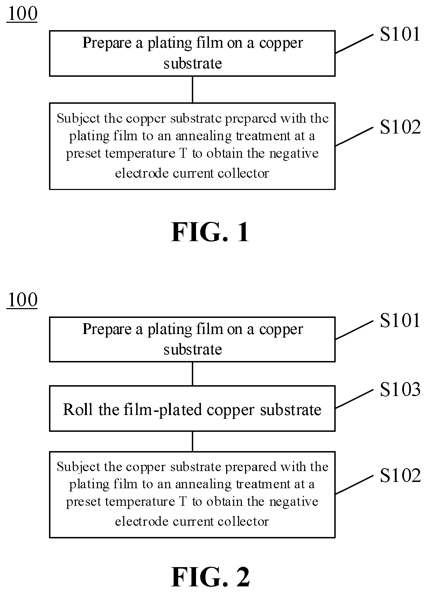

FIG. 1 is a schematic flowchart of a method 100 for preparing a negative electrode current collector according to the present application. As shown in FIG. 1, the method 100 comprises:
S101. preparing a plating film on a copper substrate; and
S102. subjecting the copper substrate prepared with the plating film to an annealing treatment at a preset temperature T to obtain the negative electrode current collector.

The plating film comprises a lithium-philic metal.

Specifically, a plating film containing a lithium-philic metal can be prepared on a copper substrate by any method, and then, the copper substrate plated with the plating film is subjected to an annealing treatment at preset temperature T. During the process of the annealing treatment, as driven by thermodynamics, the atoms of the lithium-philic metal mutually diffuse with the copper atoms in the copper substrate, so that a lithium-philic metal-copper alloy can be formed at the position of contact between the copper substrate and the plating layer. In addition, during the annealing process, the effect of thermodynamics is also conducive to the lateral diffusion of the plating film on the surface of the copper substrate, making the surface of the annealed plating layer smoother and reducing the generation and growth of lithium dendrites during cycling. It should be understood that after annealing is completed, the plating film is converted into at least part of the plating layer.

On this basis, the negative electrode current collector prepared by the method 100 provided in the embodiment of the present application has a plating layer comprising a lithium-philic metal, and the plating layer has a strong bonding force with the copper substrate, which solves the problem of the plating layer easily falling off during the cycling of the lithium metal battery and can help improve the cycling performance of the lithium metal battery. Moreover, the negative electrode current collector prepared by the method 100 provided in the embodiment of the present application has improved uniformity of the plating layer, thereby alleviating the phenomenon of lithium ion agglomeration during the deposition process, helping lithium ions to be more evenly deposited on the surface of the negative electrode current collector, thereby inhibiting lithium precipitation and lithium dendrite formation and improving the cycling performance of the lithium metal battery.

Optionally, in one embodiment, an annealing atmosphere of the annealing treatment comprises at least one of nitrogen, argon, a nitrogen-hydrogen mixed gas, and a mixed gas of an inert gas and hydrogen.

Specifically, during the annealing process, it is necessary to consider the possibility of oxidation of the copper substrate and the plating film. Therefore, selecting the above gas as the annealing atmosphere can protect the copper substrate and the plating film from being oxidized; especially in some atmospheres mixed with reducing gases (for example, a mixed gas of an inert gas and hydrogen), the possibility of oxidation of the plating film and the copper substrate can be further reduced. By way of example, the mixed gas of the inert gas and hydrogen may be an argon-hydrogen mixed gas.

Optionally, in one embodiment, in the mixed gas of the inert gas and hydrogen, the volume content of hydrogen, V_{H2}%, satisfies 1% ≤ V_{H2}% ≤ 2%, optionally, 1% ≤ V_{H2}% ≤ 1.5%.

Specifically, V_{H2}% can be 1%, 1.2%, 1.4%, 1.6%, 1.8%, or 2%, or the value thereof is within a range obtained by combining any two of the above values.

Introducing hydrogen into the inert gas can further reduce the possibility of oxidation of the copper substrate and the plating film during annealing. On the one hand, when the volume content of hydrogen is too low, the effect thereof on preventing oxidation of the copper substrate and the plating film is limited; on the other hand, hydrogen is a flammable and explosive gas, so an excessively high volume content thereof easily causes safety accidents.

On this basis, by controlling the volume content of hydrogen in the mixed gas of the inert gas and hydrogen within an appropriate range, the embodiments of the present application can effectively protect the plating film and the copper substrate from being oxidized during annealing while also reducing the possibility of safety accidents.

Optionally, in one embodiment, the lithium-philic metal comprises at least one of Sn, Mg, Zn, Bi, Pb, Au, Ag, or Al.

Optionally, in one embodiment, the copper substrate includes copper foil and foam copper; optionally, the copper substrate is foam copper.

Specifically, the copper substrate may be a copper foil, foam copper, or other copper substrates having a two-dimensional or three-dimensional structure. Compared with a copper substrate with a two-dimensional structure, a copper substrate with a three-dimensional structure (such as foam copper) has a larger specific surface area, which makes the current density on the negative electrode current collector smaller, so that the possibility of nucleation and growth of lithium dendrites on the negative electrode current collector during lithium ion deposition can be effectively reduced. In addition, the three-dimensional structure provides sufficient space for the expansion of the negative electrode caused by lithium ion deposition.

On this basis, in the embodiments of the present application, selecting a copper substrate with a three-dimensional structure (such as foam copper) as part of the negative electrode current collector can effectively inhibit lithium precipitation and lithium dendrite formation, while helping to improve the problem of the expansion of the negative electrode during the cycling of the lithium metal battery.

FIG. 2 is another schematic flowchart of a method for preparing a negative electrode current collector according to an embodiment of the present application.

Optionally, as shown in FIG. 2, before the annealing treatment, the method 100 further comprises:
S103. rolling the plated copper substrate.

For example, the thickness of commercially available foam copper may be 500 µm or more. When applied to a lithium metal battery, it needs to be compressed to a certain thickness in consideration of factors such as the volume energy density of the battery. This process can be achieved by rolling. It should be understood that rolling can be either cold rolling or hot rolling, which is not limited in the present application.

Considering that the lithium-philic metal in the plating film may form brittle phases during the annealing treatment, these brittle phases may be damaged during the rolling process, thereby affecting the bonding force between the plating layer and the copper substrate, making the effect of the annealing treatment less than expected.

On this basis, in the embodiments of the present application, by providing a rolling step before the annealing treatment, a better heat treatment effect can be achieved, so that the bonding force between the plating layer and the copper substrate after annealing is stronger.

Optionally, in one embodiment, after the annealing treatment, the negative electrode current collector is rolled.

From the perspective of industrial production, during the annealing treatment, the copper substrate plated with the plating layer may shrink and the thickness may change in local positions.

On this basis, in the embodiments of the present application, by providing a rolling step after the annealing treatment, the consistency of the thickness of the negative electrode current collector can be improved.

Optionally, in one embodiment, where the lithium-philic metal includes Sn, T satisfies 200°C ≤ T ≤ 800°C; or where the lithium-philic metal includes Mg or Zn, T satisfies 500°C ≤ T ≤ 1000°C; or where the lithium-philic metal includes Bi, T satisfies 450°C ≤ T ≤ 650°C; or where the lithium-philic metal includes Pb, T satisfies 600°C ≤ T ≤ 800°C; or where the lithium-philic metal includes Au, T satisfies 900°C ≤ T ≤ 1100°C; or where the lithium-philic metal includes Ag, T satisfies 800°C ≤ T ≤ 1000°C; or where the lithium-philic metal includes Al, T satisfies 600°C ≤ T ≤ 700°C.

Specifically, when the lithium-philic metal in the plating film is different, the corresponding temperature range of the annealing treatment can be set according to the type of the lithium-philic metal. On the one hand, the lower limit of the temperature of the annealing treatment cannot be too low, which is not conducive to the mutual diffusion between the atoms of the lithium-philic metal and copper atoms; on the other hand, the temperature of the annealing treatment cannot be too high, which may cause the diffusion of the lithium-philic metal in the copper substrate to be more chaotic, or destroy the lattice structure of the copper substrate itself, affecting the performance of the negative electrode current collector.

Therefore, in the embodiments of the present application, depending on the lithium-philic metal, the temperature of the annealing treatment is controlled within an appropriate range, so that the impact of the annealing treatment on the performance of the negative electrode current collector can be reduced while the reliability of the negative electrode current collector can be improved.

Optionally, in one embodiment, T is greater than or equal to the melting point of the lithium-philic metal.

In the embodiments of the present application, by controlling T to be greater than or equal to the melting point of the lithium-philic metal, so that the process of mutual diffusion between the atoms of the lithium-philic metal and the copper atoms is more intense. In addition, since the lithium-philic metal plating layer is in a molten state at this time, it is more conducive to the lateral diffusion of the plating layer on the surface of the copper substrate, which can further improve the uniformity of the plating layer on the surface of the copper substrate after annealing.

Optionally, in one embodiment, the negative electrode current collector is applied to a lithium metal battery.

Optionally, in one embodiment, the preparation of the plating film on the copper substrate comprises: preparing the plating film on the copper substrate by magnetron sputtering.

Specifically, magnetron sputtering is an efficient physical plating method. However, compared with chemical plating (e.g., chemical vapor deposition), the non-uniformity of physical plating is more prominent. Therefore, in combination with the foregoing method 100 for preparing a negative electrode current collector, a plating film is prepared by magnetron sputtering, and then, an annealing treatment is performed to improve the uniformity of the plating layer. The combination of the two helps to improve the production efficiency of the negative electrode current collector while the reliability of the negative electrode current collector is improved.

Optionally, in one embodiment, the areal density ρ of the plating film satisfies 2 g/m² ≤ ρ ≤ 4 g/m², optionally, 2 g/m² ≤ ρ ≤ 3 g/m².

Specifically, ρ can be 2 g/m², 2.2 g/m², 2.4 g/m², 2.6 g/m², 2.8 g/m², 3 g/m², 3.2 g/m², 3.4 g/m², 3.6 g/m², 3.8 g/m², 4 g/m², or the value thereof is within a range obtained by combining any two of the above values.

Optionally, in one embodiment, the holding time t of the annealing treatment satisfies 20 min ≤ t ≤ 60 min, optionally, 25 ≤ t ≤ 40 min.

Specifically, t can be 20 min, 22 min, 24 min, 26 min, 28 min, 30 min, 32 min, 34 min, 36 min, 38 min, 40 min, 42 min, 44 min, 46 min, 48 min, 50 min, 52 min, 54 min, 56 min, 58 min, 60 min, or the value thereof is within a range obtained by combining any two of the above values.

It should be understood that the "holding time of the annealing treatment" may also be referred to as "annealing time" or "holding time" in some other examples, and when setting the holding time, both the effect of the annealing treatment and the efficiency of industrial production are necessarily considered. On the one hand, an excessively short holding time is not conducive to mutual diffusion between the lithium-philic metal and the copper substrate, affecting the bonding force between the plating layer and the copper substrate, thus affecting the reliability of the negative electrode current collector; in addition, it is also detrimental to the lateral diffusion of the lithium-philic metal on the surface of the copper substrate, affecting the uniformity of the plating layer. On the other hand, an excessively long holding time is detrimental to improving production efficiency.

On this basis, in the embodiments of the present application, controlling the holding time of the annealing treatment within an appropriate range helps to make the current collector convenient for industrial production while improving the reliability of the negative electrode current collector; the negative electrode current collector with improved reliability can effectively improve the cycling performance of the lithium metal battery.

For example, where plating is carried out by magnetron sputtering and the lithium-philic metal is Sn, it can be controlled such that 200°C ≤ T ≤ 700°C, and the heating rate of the annealing treatment is 5°C/min. That is to say, T can be 200°C, 250°C, 300°C, 350°C, 400°C, 450°C, 500°C, 550°C, 600°C, 650°C, 700°C, or the value thereof is within a range obtained by combining any two of the above values. Furthermore, it can be controlled such that 400°C ≤ T ≤ 700°C, that is, T is controlled to be higher than the melting point of Sn, so that the mutual diffusion between Sn atoms and Cu atoms is more intense, the plating layer is more intimately bonded to the copper substrate after annealing, and the plating layer is more uniform on the surface of the copper substrate.

Optionally, in one embodiment, the preparation of the plating film on the copper substrate comprises: preparing the plating film on the copper substrate by chemical electroplating.

Specifically, chemical electroplating is a common chemical plating method, in which an electrochemical reaction usually occurs to reduce metal ions on the surface of the substrate into a metal, thereby forming a plating layer. The plating film obtained by chemical electroplating has a relatively smooth surface and good uniformity.

Optionally, the areal density ρ of the plating film satisfies 1.5 g/m² ≤ ρ ≤ 3 g/m².

Specifically, ρ can be 1.5 g/m², 1.6 g/m², 1.7 g/m², 1.8 g/m², 1.9 g/m², 2.0 g/m², 2.1 g/m², 2.2 g/m², 2.3 g/m², 2.4 g/m², 2.5 g/m², 2.6 g/m², 2.7 g/m², 2.8 g/m², 2.9 g/m², 3.0 g/m², or the value thereof is within a range obtained by combining any two of the above values.

Where plating is carried out by chemical electroplating, the areal density of the plating film can be controlled to meet the above requirements. On the one hand, if the areal density is too small, part of the surface of the copper substrate may not have a plating film; on the other hand, if the areal density is too large, the plating film may be too thick, affecting the degree of diffusion between the atoms of the lithium-philic metal and the atoms of the copper substrate.

Thus, by controlling the areal density of the plating film within the above range, a negative electrode current collector with high reliability and the ability to induce uniform deposition of lithium can be prepared.

Optionally, the holding time t of the annealing treatment satisfies 30 min ≤ t ≤ 60 min.

By way of example, where plating is carried out by chemical electroplating and the lithium-philic metal is Sn, it can be controlled such that 700°C ≤ T ≤ 800°C, and the heating rate v of the annealing treatment satisfies 2°C/min ≤ v ≤ 3°C/min. That is to say, T can be 700°C, 710°C, 720°C, 730°C, 740°C, 750°C, 760°C, 770°C, 780°C, 790°C, 780°C, or the value thereof is within a range obtained by combining any two of the above values. v can be 2°C/min, 2.1°C/min, 2.2°C/min, 2.3°C/min, 2.4°C/min, 2.5°C/min, 2.6°C/min, 2.7°C/min, 2.8°C/min, 2.9°C/min, 3 °C/min, or the value thereof is within a range obtained by combining any two of the above values.

The Sn plating film prepared by chemical electroplating has a relatively good uniformity, and the possibility of leaving some loose agglomerated Sn particles on the surface of the negative electrode current collector after annealing is relatively low. Sn can be completely diffused into the copper substrate, and after a relatively high temperature annealing treatment process, α copper (tin) can be generated. In addition, controlling the heating rate of the annealing treatment within a smaller range helps to make the lateral diffusion of Sn on the surface of the copper substrate more sufficient, further reducing the possibility of leaving some loose agglomerated Sn particles on the surface of the negative electrode current collector after annealing.

An embodiment of the present application further provides a negative electrode current collector. The negative electrode current collector is prepared by the method 100 according to any of the foregoing embodiments and can achieve corresponding technical effects, which will not be described in detail herein.

Next, the specific structure of a negative electrode current collector provided in the present application is introduced.

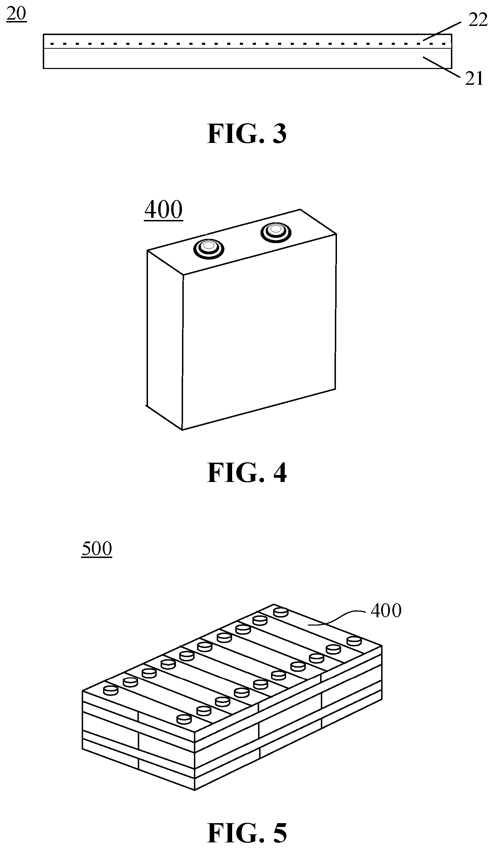

FIG. 3 is a schematic structural view of a negative electrode current collector in an embodiment of the present application. As shown in FIG. 3, the negative electrode current collector 20 comprises a copper substrate 21 and a plating layer 22 arranged on the copper substrate 21. The plating layer 22 comprises a lithium-philic metal and a lithium-philic metal-copper alloy.

Specifically, the plating layer 22 is obtained by annealing the plating film in the foregoing embodiment. During the annealing of the plating film, due to thermodynamic driving, the atoms of the lithium-philic metal and the copper atoms diffuse with each other to form an alloy phase, namely the lithium-philic metal-copper alloy. Thus, the side of the plating layer 22 close to the negative electrode current collector 20 has a lithium-philic metal-copper alloy.

Optionally, in one embodiment, the lithium-philic metal comprises at least one of Sn, Mg, Zn, Bi, Pb, Au, Ag, or Al.

Optionally, in one embodiment, the copper substrate 21 includes at least one of a copper foil and foam copper; optionally, the copper substrate is foam copper.

Optionally, in one embodiment, the plating layer 22 is prepared by magnetron sputtering and an annealing treatment.

Optionally, in one embodiment, the annealing temperature of the annealing treatment is preset temperature T, and T is greater than or equal to the melting point of the lithium-philic metal.

Optionally, in one embodiment, an annealing atmosphere of the annealing treatment comprises at least one of nitrogen, argon, a nitrogen-hydrogen mixed gas, and a mixed gas of an inert gas and hydrogen.

Optionally, in one embodiment, in the mixed gas of the inert gas and hydrogen, the volume percentage of hydrogen, V_{H2}%, satisfies 1% ≤ V_{H2}% ≤ 2%, optionally, 1% ≤ V_{H2}% ≤ 1.5%.

Optionally, in one embodiment, where the lithium-philic metal includes Sn, T satisfies 200°C ≤ T ≤ 800°C; or where the lithium-philic metal includes Mg or Zn, T satisfies 500°C ≤ T ≤ 1000°C; or where the lithium-philic metal includes Bi, T satisfies 450°C ≤ T ≤ 650°C; or where the lithium-philic metal includes Pb, T satisfies 600°C ≤ T ≤ 800°C; or where the lithium-philic metal includes Au, T satisfies 900°C ≤ T ≤ 1100°C; or where the lithium-philic metal includes Ag, T satisfies 800°C ≤ T ≤ 1000°C; or where the lithium-philic metal includes Al, T satisfies 600°C ≤ T ≤ 700°C.

Optionally, in one embodiment, the negative electrode current collector 20 is applied to a lithium metal battery.

Generally, the lithium metal battery comprises a positive electrode plate, a negative electrode plate, an electrolyte solution, and a separator. The various parts of the lithium metal battery provided in the present application will be introduced below.

### [Negative electrode plate]

The present application further provides a negative electrode plate. The negative electrode plate comprises the negative electrode current collector 20 according to any one of the foregoing embodiments or a negative electrode current collector 20 prepared by the method 100.

In one example, the negative electrode plate further comprises a negative electrode film layer arranged on at least one surface of the negative electrode current collector, and the negative electrode film layer comprises a negative electrode active material.

For example, the negative electrode current collector has two surfaces opposite to each other in a thickness direction of the negative electrode current collector, and the negative electrode film layer is arranged on either or both of the two opposite surfaces of the negative electrode current collector.

In addition to the negative electrode current collector mentioned in the foregoing embodiments of the present application, the negative electrode plate can also be other metal foils or composite current collectors. For example, as the metal foil, a copper foil can be used. The composite current collector can comprise a polymer material substrate layer and a metal layer formed on at least one surface of the polymer material substrate. The composite current collector can be formed by forming a metal material (copper, copper alloys, nickel, nickel alloys, titanium, titanium alloys, silver and silver alloys, etc.) on a polymer material substrate (such as substrate of polypropylene (PP), polyethylene terephthalate (PET), polybutylene terephthalate (PBT), polystyrene (PS), polyethylene (PE), etc.).

In a lithium metal battery, the negative electrode plate of the battery can be a negative electrode current collector, that is, the negative electrode current collector directly serves as the negative electrode plate. This type of lithium metal battery can also be referred to as "negative electrode-free battery". During the charging process, lithium ions deintercalated from the positive electrode active material are deposited on the negative electrode current collector to form lithium metal (that is, the negative electrode active material is lithium metal). In some other embodiments, in order to ensure normal use of the negative electrode plate or to facilitate the deposition of lithium metal on the negative electrode current collector, a conductive film layer may be deposited on the negative electrode current collector.

In one embodiment, the negative electrode active material can be a negative electrode active material well known in the art for lithium metal batteries. By way of example, the negative electrode active material can include at least one of the following materials: a carbon-based material, an alloy material, a titanium-based material, lithium metal, a carbon-based material deposited with lithium metal, a composite material containing lithium metal, an alloy material containing lithium metal, etc. The above carbon-based material includes but is not limited to graphite, soft carbon, hard carbon, carbon microspheres, and carbon fibers. The above alloy material includes but is not limited to a sodium-tin alloy, a sodium-germanium alloy, and a sodium-antimony alloy. The above titanium-based material includes but is not limited to titanium dioxide, a titanate, and titanium phosphate. In the present application, other materials that can be used as negative electrode active materials for lithium metal batteries may also be used. Only a single one of or a combination of two or more of these negative electrode active materials can be used.

The above negative electrode plate can be prepared according to a conventional method in the art. For example, a copper foil or a copper foil with a conductive film layer arranged on at least one surface of the copper foil may be used as the negative electrode plate. The conductive film layer can be arranged on at least one surface of the negative electrode current collector by methods such as physical vapor deposition (PVD), spin coating, electroplating, and chemical vapor deposition (CVD).

### [Positive electrode plate]

The positive electrode plate comprises a positive electrode current collector and a positive electrode active material layer provided on at least one surface of the positive electrode current collector.

By way of example, the positive electrode current collector has two surfaces opposite to each other in a thickness direction of the positive electrode current collector, and the positive electrode active material layer is arranged on either or both of the two opposite surfaces of the positive electrode current collector.

In one embodiment, the positive electrode current collector can be a metal foil or a composite current collector. For example, as the metal foil, an aluminum foil can be used. The composite current collector can comprise a polymer material substrate layer and a metal layer formed on at least one surface of the polymer material substrate layer. The composite current collector can be formed by forming a metal material (aluminum, aluminum alloys, nickel, nickel alloys, titanium, titanium alloys, silver and silver alloys, etc.) on a polymer material substrate (such as polypropylene (PP), polyethylene terephthalate (PET), polybutylene terephthalate (PBT), polystyrene (PS), polyethylene (PE), etc.).

In one embodiment, the positive electrode active material can be a positive electrode active material well known in the art for batteries. By way of example, the positive electrode active material can comprise at least one of the following materials: a lithium-containing phosphate with an olivine structure, a lithium transition metal oxide, and respective modified compounds thereof. However, the present application is not limited to these materials, and other conventional materials that can be used as positive electrode active materials for batteries may also be used. Only a single one of or a combination of two or more of these positive electrode active materials can be used. Examples of lithium transition metal oxides can include, but are not limited to, at least one of lithium cobalt oxide (e.g., LiCoO₂), lithium nickel oxide (e.g., LiNiO₂), lithium manganese oxide (e.g., LiMnO₂ and LiMn₂O₄), lithium nickel cobalt oxide, lithium manganese cobalt oxide, lithium nickel manganese oxide, lithium nickel cobalt manganese oxide (e.g., LiNi_{1/3}Co_{1/3}Mn_{1/3}O₂ (also abbreviated as NCM333), LiNi_{0.5}Co_{0.2}Mn_{0.3}O₂ (also abbreviated as NCM523), LiNi_{0.5}Co_{0.25}Mn_{0.25}O₂ (also abbreviated as NCM211), LiNi_{0.6}Co_{0.2}Mn_{0.2}O₂ (also abbreviated as NCM622), LiNi_{0.8}Co_{0.1}Mn_{0.1}O₂ (also abbreviated as NCM811)), lithium nickel cobalt aluminum oxide (e.g., LiNi_{0.85}Co_{0.15}Al_{0.05}O₂), modified compounds thereof, etc. Examples of lithium-containing phosphates with an olivine structure may include, but are not limited to, at least one of lithium iron phosphate (e.g., LiFePO₄ (also abbreviated as LFP)), lithium iron phosphate-carbon composite, lithium manganese phosphate (e.g., LiMnPO₄), lithium manganese phosphate-carbon composite, lithium iron manganese phosphate, and lithium iron manganese phosphate-carbon composite. The charging and discharging process of the battery is accompanied by deintercalation and consumption of Li, and the molar content of Li in the positive electrode active material varies as the state to which the battery is discharged varies. In a list of positive electrode active materials in the present application, the molar content of Li is at the initial state of the material, i.e., the state before addition, and the molar content of Li may change after the positive electrode active material is applied to the battery system and subjected to charge-discharge cycling. In a list of positive electrode active materials in the present application, the molar content of O is only the value in an ideal state. The release of oxygen from the lattice will cause the molar content of O to change. The practical molar content of O may fluctuate.

In one embodiment, the positive electrode active material layer further comprises a binder. By way of example, the binder can include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In one embodiment, the positive electrode active material layer further comprises a conductive agent. By way of example, the conductive agent can include at least one of superconducting carbon, acetylene black, carbon black, Ketjen black, carbon dots, carbon nanotubes, graphene, and carbon nanofibers.

In one embodiment, the positive electrode plate can be prepared by forming a positive electrode slurry from the above components for preparing a positive electrode plate. For example, the first positive electrode active material and/or second positive electrode active material, the conductive agent, the binder, and any other components are dispersed in a solvent (e.g., N-methyl pyrrolidone) to form a positive electrode slurry. Then, the positive electrode slurry is applied to a positive electrode current collector, followed by procedures such as drying and cold rolling, to provide the positive electrode plate.

### [Electrolyte solution]

The electrolyte solution serves to conduct ions between the positive electrode plate and the negative electrode plate. The type of the electrolyte solution is not specifically limited in the present application and can be selected according to requirements. The electrolyte solution comprises an electrolyte salt and a solvent.

In one embodiment, the electrolyte salt can be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalato)borate, lithium difluorobis(oxalato)phosphate, and lithium tetrafluoro(oxalato)phosphate.

In one embodiment, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, methyl ethyl sulfone, and diethyl sulfone.

In one embodiment, the electrolyte solution can further comprise an additive, and the additive can include a negative electrode film-forming additive and a positive electrode film-forming additive and can further include additives that can improve some properties of the battery, for example, an additive that improves the overcharging performance of the battery and an additive that improves the high- or low-temperature performance of the battery.

### [Separator]

In one embodiment, the battery further comprises a separator. The type of the separator is not particularly limited in the present application, and for example, any well-known separator film having good chemical stability, mechanical stability, and a porous structure can be selected.

In one embodiment, the material of the separator film can be selected from at least one of glass fibers, non-woven fabric, polyethylene, polypropylene, and polyvinylidene fluoride. The separator film can be either a single-layer thin film or a multi-layer composite thin film without special limitations. When the separator film is a multi-layer composite thin film, the material of each layer may be the same or different, which is not particularly limited.

The present application provides a lithium metal battery. The lithium metal battery comprises the negative electrode plate according to any one of the foregoing embodiments. In some examples, the lithium metal battery can also be referred to as a lithium metal battery cell.

Optionally, in one embodiment, the negative electrode plate, the positive electrode plate, and the separator can be made into an electrode assembly by a winding process or a lamination process.

Optionally, in one embodiment, the lithium metal battery cell can comprise an outer package. The outer package can be used for encapsulating the above electrode assembly and electrolyte solution.

Optionally, in one embodiment, the outer package of the lithium metal battery cell can be a hard shell, such as a hard plastic shell, an aluminum shell, and a steel shell. The outer package of the lithium metal battery cell can also be a soft package, such as a pouch-type soft package. The material of the soft package can be plastic, and examples of the plastic can include polypropylene, polybutylene terephthalate, polybutylene succinate, etc.

The shape of the lithium metal battery cell is not particularly limited in the present application, and the secondary battery can be cylindrical, prismatic, or in any other shape. For example, FIG. 4 is a lithium metal battery cell 400 with a prismatic structure as an example.

FIG. 5 is a battery module 500 as an example. With reference to FIG. 5, in the battery module 500, a plurality of lithium metal battery cells 400 can be arranged sequentially along the length direction of the battery module 500. Of course, they can also be arranged in any other manner. The plurality of lithium metal battery cells 400 can be further fixed by fasteners.

Optionally, in one embodiment, the battery module 500 can also comprise battery cells of other chemical systems, such as lithium-ion batteries, sodium-ion batteries, and magnesium-ion batteries.

Optionally, in one embodiment, the battery module 500 can further comprise a shell having an accommodating space, in which the plurality of lithium metal battery cells 400 are accommodated.

Optionally, in one embodiment, the above battery module 500 can be further assembled into a battery, the number of battery modules 500 comprised in the battery can be one or more, and the specific number can be selected by those skilled in the art based on the application and capacity of the battery.

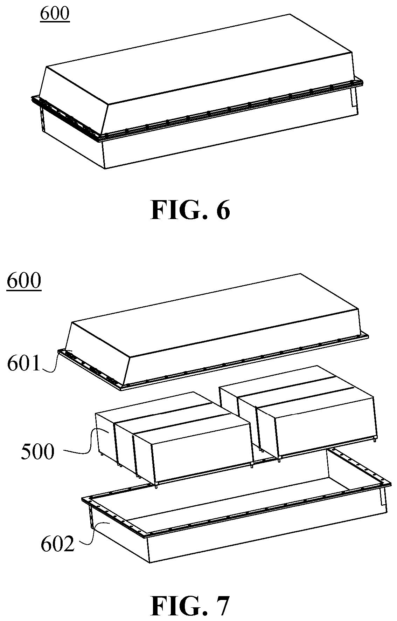

FIGs. 6 and 7 are a battery 600 as an example. Referring to FIGs. 6 and 7, the battery 600 can comprise a battery box and a plurality of battery modules 500 arranged in the battery box. The battery box comprises an upper box 601 and a lower box 602. The upper box 601 can cover the lower box 602 to form an enclosed space for accommodating the battery module 500. The plurality of battery modules 500 can be arranged in the battery box in any manner.

It should be understood that in some other embodiments, the above battery 600 can also be referred to as a battery pack. The lithium metal battery cell 400 can be assembled into a battery module 500 in advance, and the battery 600 is assembled from the battery module 500. The battery 600 can also be directly assembled from the lithium metal battery cells 400, with omission of the intermediate form of the battery module 500.

In addition, the present application further provides an electrical apparatus. The electrical apparatus comprises the lithium metal battery according to any one of the foregoing embodiments.

In another embodiment, the electrical apparatus comprises at least one of the lithium metal battery cell 400, the battery module 500, or the battery 600 as provided in the present application. The lithium metal battery cell 400, the battery module 500, or the battery 600 can be used either as a power source of the electrical apparatus, or as an energy storage unit of the electrical apparatus. The electrical apparatus can include, but is not limited to, a mobile apparatus (for example, a mobile phone or a laptop), an electric vehicle (for example, an all-electric vehicle, a hybrid electric vehicle, a plug-in hybrid electric vehicle, an electric bicycle, an electric scooter, an electric golf cart, or an electric truck), an electric train, a ship, a satellite, an energy storage system, etc.

For the electrical apparatus, the lithium metal battery cell 400, the battery module 500, or the battery 600 can be selected based on use requirements thereof.

Here is an electrical apparatus as an example. The electrical apparatus is an all-electric vehicle, a hybrid electric vehicle, a plug-in hybrid electric vehicle, etc. To satisfy the need of the electrical apparatus for a high power and high energy density of secondary batteries, a battery pack or a battery module can be used.

The device used as another example can be, for example, a mobile phone, a tablet computer, a laptop, etc. The device is generally required to be light and thin and can use a secondary battery as a power source.

Embodiments of the present application are described below. The embodiments described below are illustrative and only used to explain the present application, and cannot be construed as limiting the present application. In embodiments in which no specific technologies or conditions are specified, technologies or conditions described in the literature in the art or product specifications are followed. The reagents or instruments used without manufacturer indicated are all commercially available conventional products.

### [Examples 1-21 and Comparative Examples 1-5]

### Example 1

### (1) Preparation of negative electrode current collector

Foam copper, used as a copper substrate, was plated with Sn by magnetron sputtering and then subjected to an annealing treatment. The atmosphere of the annealing treatment was Ar, the temperature of the annealing treatment was T = 200°C, and the time of the annealing treatment was t = 30 min. Cold rolling was then carried out to obtain the negative electrode current collector. The areal density of plated Sn was ρ = 2 g/m², and the heating rate of the annealing treatment was 5°C/min.

### (2) Preparation of negative electrode plate

The negative electrode current collector in (1) was directly used as a negative electrode plate to participate in the assembly of a lithium metal battery, thereby obtaining a "negative electrode-free" lithium metal battery.

### (3) Preparation of positive electrode plate

The positive electrode active material lithium iron phosphate, the conductive agent carbon black, and the binder polyvinylidene fluoride (PVDF) at a mass ratio of 8:1:1 were dissolved in the solvent N-methyl pyrrolidone and uniformly mixed to obtain a positive electrode slurry. Subsequently, the positive electrode slurry was uniformly applied to the positive electrode current collector aluminum foil. After drying in an oven at 80°C, a positive electrode active material layer was obtained, and after further rolling and slitting, the positive electrode plate was obtained.

### (4) Preparation of half-battery

The above negative electrode plate, separator, and lithium plate were stacked in order so that the separator was between the negative electrode plate and the lithium plate and can isolate the negative electrode plate from the lithium plate, and the above stacked components were then assembled into a button battery, i.e., the lithium metal half-battery. The electrolyte solution used was 1 M LiFSI (the solvent was DME), and the separator film used was a PE film with a thickness of 12 µm.

### (5) Preparation of full battery

The above positive electrode plate, separator, and negative electrode plate were stacked in order so that the separator was between the positive electrode plate and the negative electrode plate and can isolate the positive electrode plate from the negative electrode plate, and the above stacked components were then assembled into a button battery, i.e., the lithium metal full battery. The electrolyte solution used was 1 M LiFSI (the solvent was DME), and the separator film used was a 12 µm PE film.

### Examples 2-5

Compared with Example 1, the temperature T of the annealing treatment was different in Examples 2-5.

### Example 6

Compared with Example 1, Example 6 was different in that during the preparation of the negative electrode plate, Sn was plated by chemical electroplating, the areal density of the plated Sn was ρ = 1.8 g/m², the heating rate v of the annealing treatment was 3°C/min, and the temperature T of the annealing treatment was 500°C.

### Examples 7-9

Compared with Example 6, the temperature T of the annealing treatment was different in Examples 7-9. Compared with Example 6, Example 8 was different in the annealing temperature T and also the heating rate. The heating rate v of the annealing treatment in Example 8 was 5°C/min.

### Examples 10-14

Compared with Example 3, the holding time t of the annealing treatment was different in Examples 10-14.

### Examples 15-17

Compared with Example 7, the holding time t of the annealing treatment was different in Examples 15-17.

### Examples 18-21

Compared with Example 3, the atmosphere of the annealing treatment was different in Examples 18-21.

### Example 22

Compared with Example 1, Example 22 was different in that Ag was plated by magnetron sputtering, and the temperature of the annealing treatment was T = 800°C.

### Examples 23-24

Compared with Example 22, the temperature T of the annealing treatment was different in Examples 23-24.

### Example 25

Compared with Example 1, Example 27 was different in that Zn was plated by magnetron sputtering, and the temperature of the annealing treatment was T = 500°C.

### Examples 26-28

Compared with Example 25, the temperature T of the annealing treatment was different in Examples 26-28.

### Examples 29-30

Compared with Example 3, Examples 29-30 were different in the areal density ρ of Sn plated by magnetron sputtering.

### Examples 31-33

Compared with Example 7, Examples 31-33 were different in the areal density ρ of Sn plated by chemical electroplating.

### Example 34

Compared with Example 3, Example 34 was different in that Sn was plated by magnetron sputtering, followed by cold rolling and then an annealing treatment.

### Example 35

Compared with Example 3, Example 35 was different in that the copper substrate was a copper foil.

### Comparative Example 1

Compared with Example 1, Comparative Example 1 was different in no annealing treatment process.

### Comparative Example 2

Compared with Example 24, Comparative Example 2 was different in no annealing treatment process.

### Comparative Example 3

Compared with Example 27, Comparative Example 3 was different in no annealing treatment process.

### Comparative Example 4

Compared with Example 9, Comparative Example 4 was different in no annealing treatment process.

The product parameters of Examples 1-38 and Comparative Examples 1-4 are detailed in Table 1.

**Table 1: Product parameters of Examples 1-35 and Comparative Examples 1-4**

| | Copper substrate | Lithium-philic metal | Plating method | ρ (g/m²) | T (°C) | v (°C/min) | t (min) | Annealing atmosphere |
|---|---|---|---|---|---|---|---|---|
| Example 1 | Foam copper | Sn | Magnetron sputtering | 2 | 200 | 5 | 30 | Ar |
| Example 2 | Foam copper | Sn | Magnetron sputtering | 2 | 400 | 5 | 30 | Ar |
| Example 3 | Foam copper | Sn | Magnetron sputtering | 2 | 500 | 5 | 30 | Ar |
| Example 4 | Foam copper | Sn | Magnetron sputtering | 2 | 600 | 5 | 30 | Ar |
| Example 5 | Foam copper | Sn | Magnetron sputtering | 2 | 800 | 5 | 30 | Ar |
| Example 6 | Foam copper | Sn | Chemical electroplating | 1.8 | 500 | 3 | 30 | Ar |
| Example 7 | Foam copper | Sn | Chemical electroplating | 1.8 | 700 | 3 | 30 | Ar |
| Example 8 | Foam copper | Sn | Chemical electroplating | 1.8 | 700 | 5 | 30 | Ar |
| Example 9 | Foam copper | Sn | Chemical electroplating | 1.8 | 800 | 3 | 30 | Ar |
| Example 10 | Foam copper | Sn | Magnetron sputtering | 2 | 500 | 5 | 20 | Ar |
| Example 11 | Foam copper | Sn | Magnetron sputtering | 2 | 500 | 5 | 25 | Ar |
| Example 12 | Foam copper | Sn | Magnetron sputtering | 2 | 500 | 5 | 30 | Ar |
| Example 13 | Foam copper | Sn | Magnetron sputtering | 2 | 500 | 5 | 40 | Ar |
| Example 14 | Foam copper | Sn | Magnetron sputtering | 2 | 500 | 5 | 60 | Ar |
| Example 15 | Foam copper | Sn | Chemical electroplating | 1.8 | 700 | 3 | 10 | Ar |
| Example 16 | Foam copper | Sn | Chemical electroplating | 1.8 | 700 | 3 | 60 | Ar |
| Example 17 | Foam copper | Sn | Chemical electroplating | 1.8 | 700 | 3 | 70 | Ar |
| Example 18 | Foam copper | Sn | Magnetron sputtering | 2 | 500 | 5 | 30 | N₂ |
| Example 19 | Foam copper | Sn | Magnetron sputtering | 2 | 500 | 5 | 30 | 1% H₂ + 99% N₂ |
| Example 20 | Foam copper | Sn | Magnetron sputtering | 2 | 500 | 5 | 30 | 1.5% H₂ + 98.5% N₂ |
| Example 21 | Foam copper | Sn | Magnetron sputtering | 2 | 500 | 5 | 30 | 2% H₂ + 98% N₂ |
| Example 22 | Foam copper | Ag | Magnetron sputtering | 2 | 800 | 5 | 30 | Ar |
| Example 23 | Foam copper | Ag | Magnetron sputtering | 2 | 900 | 5 | 30 | Ar |
| Example 24 | Foam copper | Ag | Magnetron sputtering | 2 | 1000 | 5 | 30 | Ar |
| Example 25 | Foam copper | Zn | Magnetron sputtering | 2 | 500 | 5 | 30 | Ar |
| Example 26 | Foam copper | Zn | Magnetron sputtering | 2 | 750 | 5 | 30 | Ar |
| Example 27 | Foam copper | Zn | Magnetron sputtering | 2 | 800 | 5 | 30 | Ar |
| Example 28 | Foam copper | Zn | Magnetron sputtering | 2 | 1000 | 5 | 30 | Ar |
| Example 29 | Foam copper | Sn | Magnetron sputtering | 3 | 500 | 5 | 30 | Ar |
| Example 30 | Foam copper | Sn | Magnetron sputtering | 4 | 500 | 5 | 30 | Ar |
| Example 31 | Foam copper | Sn | Chemical electroplating | 1 | 700 | 3 | 30 | Ar |
| Example 32 | Foam copper | Sn | Chemical electroplating | 1.5 | 700 | 3 | 30 | Ar |
| Example 33 | Foam copper | Sn | Chemical electroplating | 3 | 700 | 3 | 30 | Ar |
| Example 34 | Foam copper | Sn | Magnetron sputtering | 2 | 500 | 5 | 30 | Ar |
| Example 35 | Copper foil | Sn | Magnetron sputtering | 2 | 500 | 5 | 30 | Ar |
| Comparative Example 1 | Foam copper | Sn | Magnetron sputtering | 2 | / | / | / | / |
| Comparative Example 2 | Foam copper | Ag | Magnetron sputtering | 2 | / | / | / | / |
| Comparative Example 3 | Foam copper | Zn | Magnetron sputtering | 2 | / | / | / | / |
| Comparative Example 4 | Foam copper | Sn | Chemical electroplating | 1.8 | / | / | / | / |

In Table 1, "copper substrate" represents the copper substrate in the negative electrode current collector; "lithium-philic metal" represents a lithium-philic metal contained in the plating film of the negative electrode current collector; "plating method" represents a method of preparing the plating film on the copper substrate; "ρ" represents the areal density of the plating film; "T" represents the temperature of the annealing treatment; "v" represents the heating rate of the annealing treatment; "t" represents the holding time of the annealing treatment; and "annealing atmosphere" represents the atmosphere in which the annealing treatment is performed.

The product performance test of Examples 1-35 and Comparative Examples 1-4 are detailed in Table 2.

**Table 2: Performance data of Examples 1-35 and Comparative Examples 1-4**

| | First-cycle Coulombic efficiency (%) | Short-circuit time (h) | Number of cycles at 50% SOC |
|---|---|---|---|
| Example 1 | 89.8 | 94 | 61 |
| Example 2 | 90.7 | 149 | 80 |
| Example 3 | 91.2 | 168 | 82 |
| Example 4 | 92.3 | 155 | 78 |
| Example 5 | 93.6 | 112 | 69 |
| Example 6 | 89.4 | 105 | 71 |
| Example 7 | 89.7 | 121 | 96 |
| Example 8 | 88.6 | 115 | 92 |
| Example 9 | 90.1 | 132 | 98 |
| Example 10 | 89.8 | 145 | 77 |
| Example 11 | 90.5 | 155 | 79 |
| Example 12 | 91.1 | 162 | 81 |
| Example 13 | 91.5 | 166 | 82 |
| Example 14 | 91.2 | 158 | 80 |
| Example 15 | 88.8 | 115 | 81 |
| Example 16 | 89.8 | 126 | 98 |
| Example 17 | 89.6 | 119 | 96 |
| Example 18 | 91.3 | 167 | 82 |
| Example 19 | 91.8 | 174 | 84 |
| Example 20 | 92 | 178 | 87 |
| Example 21 | 92.1 | 181 | 88 |
| Example 22 | 90.8 | 105 | 60 |
| Example 23 | 92.3 | 212 | 109 |
| Example 24 | 94.6 | 168 | 89 |
| Example 25 | 88.7 | 112 | 64 |
| Example 26 | 88.8 | 145 | 66 |
| Example 27 | 89.3 | 150 | 69 |
| Example 28 | 90.2 | 115 | 59 |
| Example 29 | 91 | 177 | 83 |
| Example 30 | 90.7 | 185 | 85 |
| Example 31 | 90.1 | 96 | 57 |
| Example 32 | 89.7 | 118 | 82 |
| Example 33 | 89.1 | 111 | 76 |
| Example 34 | 92.1 | 181 | 88 |
| Example 35 | 93.1 | 156 | 70 |
| Comparative Example 1 | 86.8 | 89 | 45 |
| Comparative Example 2 | 88.5 | 93 | 52 |
| Comparative Example 3 | 84.5 | 80 | 39 |
| Comparative Example 4 | 83.2 | 66 | 42 |

In Table 2, "First-cycle Coulombic efficiency" represents the first-cycle Coulombic efficiency of the lithium metal half-battery; "short-circuit time of the half-battery" represents the time taken for the voltage to jump to 0 V when a short-circuit signal appears in the constant current discharge test of the lithium metal half-battery; and "number of cycles at 50% SOC" represents the number of cycles when the lithium metal full battery was cycled to 50% SOC.

According to the performance comparison analysis of the above Examples 1-35 and Comparative Examples 1-4, the Coulombic efficiency of the examples after the annealing treatment was better than that of the comparative examples without the annealing treatment, and the short-circuit time was increased, effectively improving the cycling performance of the lithium metal battery.

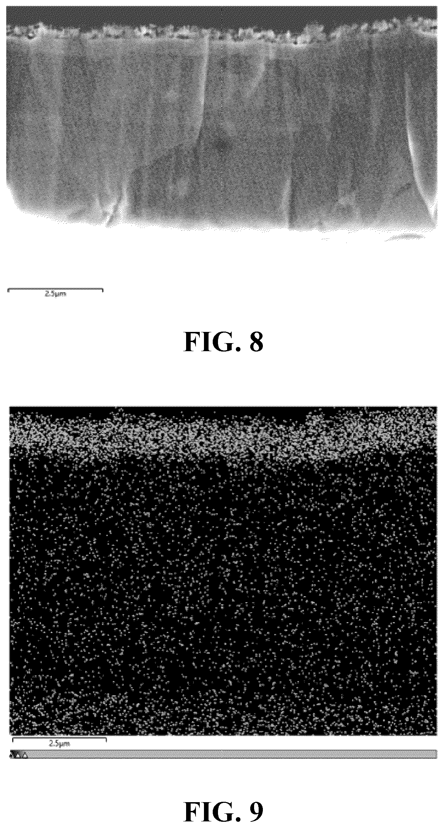

In order to facilitate intuitive observation of the effect of the annealing treatment on the negative electrode current collector, a copper foil was used as the copper substrate, and the other preparation conditions were the same as those in Example 1 (Sn plating by magnetron sputtering, annealing at 200°C) to prepare a negative electrode current collector. FIGs. 8 and 9 respectively show a scanning electron microscope (SEM) image and Sn element energy spectrum (EDS) image of the negative electrode current collector. By SEM, it can be clearly seen that the current collector after annealing comprises a copper substrate and a uniform plating layer distributed thereon, and there is a clear "transition zone" at the junction of the copper substrate and the plating layer. By EDS analysis, it can be seen that after the annealing treatment, the element Sn is not only distributed in the plating layer of the surface, but also has a significant distribution in the "transition zone" between the copper substrate and the plating layer or even inside the copper substrate. Thus, it is demonstrated that copper atoms and tin atoms mutually diffuse during the annealing treatment and can form an alloy in the "transition zone" at a certain temperature. In addition, the morphology of the plating layer after annealing is uniform, which is conducive to the uniform deposition of lithium. On this basis, it is shown that the annealing treatment can help improve the reliability between the plating layer and the copper substrate and the uniformity of the plating layer, thereby improving the reliability of the negative electrode current collector, so that when it is applied to a lithium metal battery, it can help to improve the cycling performance of the lithium metal battery.

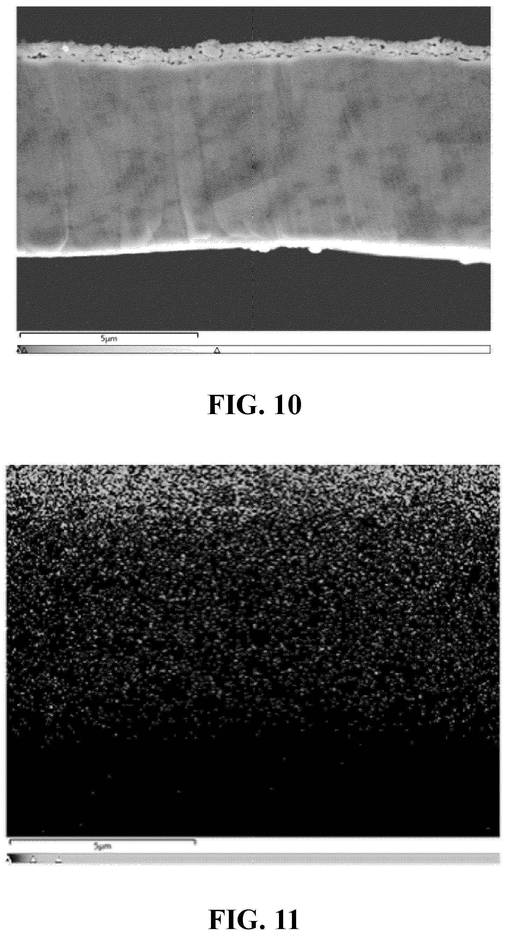

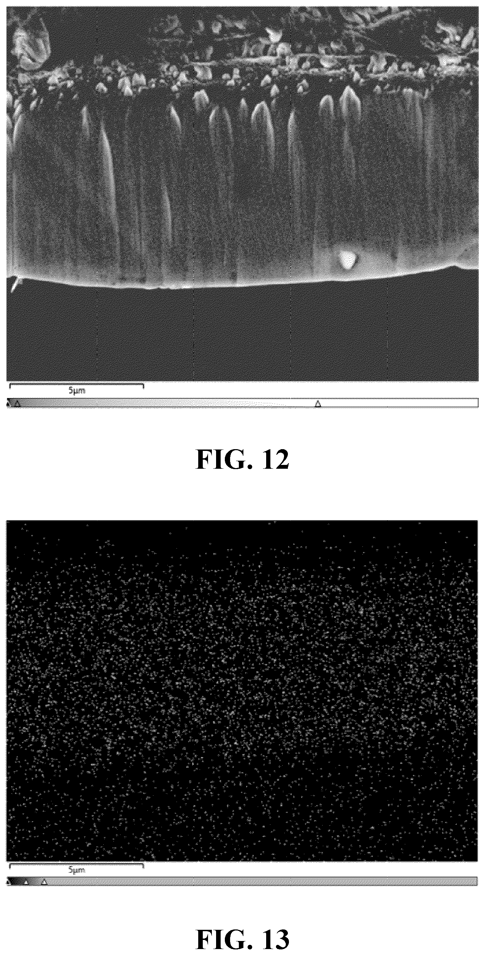

FIGs. 10 and 12 respectively show SEM images of a negative electrode current collector obtained by using a copper foil as the copper substrate, Sn plating by magnetron sputtering, and annealing at 500°C and 800°C. FIGs. 11 and 13 respectively show Sn element EDS images of the negative electrode current collector corresponding to FIGs. 10 and 12. It can be seen from FIGs. 10-13 that as the annealing temperature increases, the mutual diffusion between tin atoms and copper atoms becomes more intense and thorough, which can further improve the reliability between the plating layer and the copper substrate.

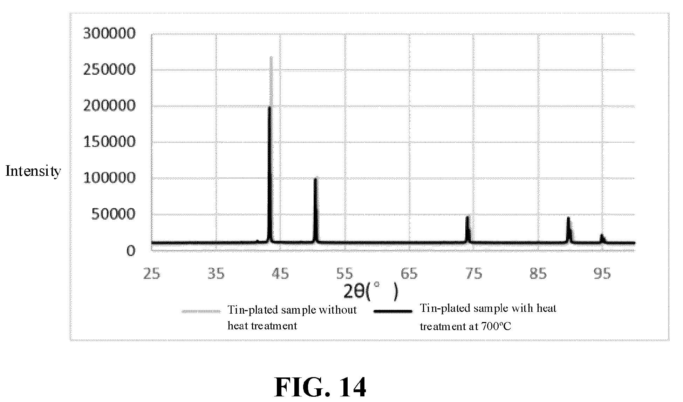

FIG. 14 is X-ray diffraction (XRD) patterns of Example 9 and Comparative Example 4, and FIG. 14 only shows characteristic peaks of copper. It can be seen from FIG. 14 that after annealing at a higher temperature, the characteristic peaks of copper have shifted to the left, and the intensity of different diffraction peaks has also changed, indicating that tin has been intercalated into the copper lattice to form α copper (tin).

Examples 1-5 and 6-9 are all examples of controlling the annealing temperature under different plating methods. Based on the foregoing electron microscope and energy spectrum analysis, combined with the performance data analysis of Examples 1-5 and 6-9, it can be seen that with the increase of the annealing temperature, the degree of mutual diffusion between the atoms of the plating film and the copper atoms during the annealing process increases, so that the degree of tightness between the plating layer and the copper substrate after annealing increases, and a copper-tin alloy can be formed at a higher temperature, which further improves the reliability of the negative electrode current collector, makes the plating layer less likely to fall off during the cycling of the lithium metal battery, improves the Coulombic efficiency of the lithium metal battery, and prolongs the short-circuit time, thereby effectively improving the cycling performance of the lithium metal battery. The cycling performance of Example 5 is slightly inferior to that of Examples 2-4, indicating that the annealing temperature cannot be infinitely high and needs to be controlled within an appropriate range. An excessively high temperature may affect the lattice structure of the copper substrate or the plating layer, affecting the performance of the negative electrode current collector in the lithium metal battery. Thus, controlling the annealing temperature within an appropriate range helps to reduce the impact of the annealing treatment on the lattice structure of the negative electrode current collector while further improving the reliability of the negative electrode current collector.

Examples 10-14 and 15-17 are all examples in which the annealing time is controlled under different plating methods. According to the performance data analysis of Examples 10-17, it can be seen that with the increase of the annealing time, the first-cycle Coulombic efficiency, short-circuit time, and number of cycles of the lithium metal battery all show a trend of first increasing and then decreasing. Thus, it is indicated that when the holding time is relatively short, the degree of mutual diffusion between the atoms of the plating layer and the copper atoms may be relatively low; and when the holding time is relatively long, other impurities may be generated and affect the production efficiency. On this basis, Examples 10-17 have shown that by controlling the holding time within an appropriate range, a negative electrode current collector with high reliability that is beneficial for improving the cycling performance of the lithium metal battery while also helping to improve production efficiency can be obtained.

Examples 18-21 have demonstrated that the negative electrode current collector provided by the present application can be prepared in different annealing atmospheres. When the annealing atmosphere contains hydrogen, the higher the hydrogen content, the lower the probability of oxidation of the plating layer and the copper substrate during the annealing process, and the Coulombic efficiency and cycling performance of the lithium metal battery are also improved.

Examples 22-24 and 25-28 have respectively demonstrated examples with annealing at different temperatures in the case of Ag plating and Zn plating. From Examples 22-28, it can also be shown that depending on the type of the lithium-philic metal in the plating film, controlling the annealing temperature within different, appropriate ranges helps to reduce the possibility of the annealing treatment damaging the lattice structure of the copper substrate while improving the reliability of the negative electrode current collector, so that when the negative electrode current collector is applied to a lithium metal battery, it can help to improve the Coulombic efficiency, short-circuit time, and cycling performance of the lithium metal battery.

Examples 29-30 and 31-33 have respectively demonstrated examples in which the areal density of the plating layer is different in the case of plating by magnetron sputtering and plating by chemical electroplating.

Example 34 has demonstrated the case where the cold rolling procedure is provided before annealing. Example 35 has demonstrated the case where the copper substrate is a copper foil.

The test methods for the physical and chemical parameters and the performance parameters involved in the examples of the present application are briefly introduced below. It should be understood that the following test methods are only illustrative, and other test methods well known in the art may also be used for testing.

### 1. Test method for first-cycle Coulombic efficiency

A lithium metal half-battery was assembled. The lithium metal half-battery was discharged and charged at a constant current at room temperature. The current density was 1 mA/cm², the discharge capacity per cycle was 1 mAh/cm², and the charging cut-off voltage was 1 V.

The first-cycle discharge capacity was denoted as C1, the first-cycle charge capacity was denoted as C2, and the first-cycle Coulombic efficiency can be calculated according to CE = C2 / C1 × 100%.

### 2. Test method for short-circuit time of half battery

The short-circuit time of the half battery was the time from the start of the lithium metal half-battery test to the beginning of the CE fluctuation that is significantly greater than 1 or much less than 1.

### 3. Test method for number of cycles of full battery

According to the test method for cyclic charge and discharge in 1., the lithium metal battery was tested and cycled for 200 cycles, and the number of cycles of the battery when the SOC was 50% was recorded.

Although the present application has been described with reference to the preferred embodiments, various improvements can be made thereto and components thereof can be replaced with equivalents without departing from the scope of the present application. In particular, the technical features mentioned in the various embodiments can be combined in any manner as long as there is no structural conflict. The present application is not limited to the particular embodiments disclosed herein, but rather includes all technical solutions falling within the scope of the claims.

## Claims

1. A negative electrode current collector, comprising:
a copper substrate and a plating layer arranged on the copper substrate, wherein
the plating layer comprises a lithium-philic metal and a lithium-philic metal-copper alloy.

2. The negative electrode current collector according to claim 1, wherein the lithium-philic metal includes at least one of Sn, Mg, Zn, Bi, Pb, Au, Ag, or Al.

3. The negative electrode current collector according to claim 1 or 2, wherein the copper substrate includes at least one of copper foil and foam copper; optionally, the copper substrate is foam copper.

4. The negative electrode current collector according to any one of claims 1-3, wherein the negative electrode current collector is prepared by an annealing treatment, and the annealing temperature of the annealing treatment is a preset temperature T;
where the lithium-philic metal includes Sn, T satisfies 200°C ≤ T ≤ 800°C; or
where the lithium-philic metal includes Mg or Sn, T satisfies 500°C ≤ T ≤ 1000°C; or
where the lithium-philic metal includes Bi, T satisfies 450°C ≤ T ≤ 650°C; or
where the lithium-philic metal includes Pb, T satisfies 600°C ≤ T ≤ 800°C; or
where the lithium-philic metal includes Au, T satisfies 900°C ≤ T ≤ 1100°C; or
where the lithium-philic metal includes Ag, T satisfies 800°C ≤ T ≤ 1000°C; or
where the lithium-philic metal includes Al, T satisfies 600°C ≤ T ≤ 700°C.

5. The negative electrode current collector according to any one of claims 1-4, wherein the negative electrode current collector is applied to a lithium metal battery.

6. The negative electrode current collector according to any one of claims 1-5, wherein the plating layer is prepared by magnetron sputtering and an annealing treatment.

7. The negative electrode current collector according to any one of claims 1-5, wherein the plating layer is prepared by chemical electroplating and annealing treatment.

8. A method for preparing a negative electrode current collector, comprising:
preparing a plating film on a copper substrate; and
subjecting the copper substrate prepared with the plating film to an annealing treatment at a preset temperature T to obtain the negative electrode current collector,
wherein the plating film comprises a lithium-philic metal.

9. The method according to claim 8, wherein an annealing atmosphere of the annealing treatment comprises at least one of nitrogen, argon, a nitrogen-hydrogen mixed gas, and a mixed gas of an inert gas and hydrogen.

10. The method according to claim 9, wherein in the mixed gas of the inert gas and hydrogen, the volume content of hydrogen, V_{H2}%, satisfies 1% ≤ V_{H2}% ≤ 2%, optionally, 1% ≤ V_{H2}% ≤ 1.5%.

11. The method according to any one of claims 8-10, wherein the lithium-philic metal includes at least one of Sn, Mg, Zn, Bi, Pb, Au, Ag, or Al.

12. The method according to any one of claims 8-11, wherein the copper substrate includes at least one of copper foil and foam copper; optionally, the copper substrate is foam copper.

13. The method according to any one of claims 8-12, wherein before the annealing treatment, the method further comprises:
rolling the plated copper substrate.

14. The method according to any one of claims 8-13, wherein
where the lithium-philic metal includes Sn, T satisfies 200°C ≤ T ≤ 800°C; or
where the lithium-philic metal includes Mg or Sn, T satisfies 500°C ≤ T ≤ 1000°C; or
where the lithium-philic metal includes Bi, T satisfies 450°C ≤ T ≤ 650°C; or
where the lithium-philic metal includes Pb, T satisfies 600°C ≤ T ≤ 800°C; or
where the lithium-philic metal includes Au, T satisfies 900°C ≤ T ≤ 1100°C; or
where the lithium-philic metal includes Ag, T satisfies 800°C ≤ T ≤ 1000°C; or
where the lithium-philic metal includes Al, T satisfies 600°C ≤ T ≤ 700°C.

15. The method according to any one of claims 8-14, wherein the negative electrode current collector is applied to a lithium metal battery.

16. The method according to any one of claims 8-15, wherein the preparation of the plating film on the copper substrate comprises:
preparing the plating film on the copper substrate by magnetron sputtering.

17. The method according to claim 16, wherein the areal density ρ of the plating film satisfies 2 g/m² ≤ ρ ≤ 4 g/m², optionally, 2 g/m² ≤ ρ ≤ 3 g/m².

18. The method according to claim 16 or 17, wherein the holding time t of the annealing treatment satisfies 20 min ≤ t ≤ 60 min, optionally, 25 min ≤ t ≤ 40 min.

19. The method according to any one of claims 8-15, wherein the preparation of the plating film on the copper substrate comprises:
preparing the plating film on the copper substrate by chemical electroplating.

20. The method according to claim 19, wherein the areal density ρ of the plating film satisfies 1.5 g/m² ≤ ρ ≤ 3 g/m².

21. The method according to claim 19 or 20, wherein the holding time t of the annealing treatment satisfies 30 min ≤ t ≤ 60 min.

22. A negative electrode plate, wherein the negative electrode plate comprises the negative electrode current collector according to any one of claims 1-7 or a negative electrode current collector prepared by the method according to any one of claims 8-21.

23. A lithium metal battery, comprising the negative electrode plate according to claim 22.

24. The lithium metal battery according to claim 24, wherein the negative electrode plate is the negative electrode current collector.

25. An electrical apparatus, comprising the lithium metal battery according to claim 23 or 24.
